# EUROPÄISCHE PATENTANMELDUNG

(11) **EP 3 693 749 A1**
(43) Veröffentlichungstag der Anmeldung: **12.08.2020**
(21) Anmeldenummer: 19155483.1
(22) Anmeldetag: 05.02.2019
(51) Int. Cl.: G01R 1/20, G01R 19/00, G01R 19/32

(54) **STROMMESSUNG DURCH SPANNUNGSMESSUNG UNTER BERÜCKSICHTIGUNG EINES TEMPERATURABHÄNGIGEN WIDERSTANDES**

(71) Anmelder: Siemens Aktiengesellschaft, 80333 München (DE)
(72) Erfinder: Kürten, Bernd, 90587 Obermichelbach (DE)

(57) **Zusammenfassung**

In einer Leitung (1) fließt ein Strom (I). Eine über einem Messabschnitt (6) der Leitung (1) abfallende Spannung (U) wird messtechnisch erfasst und einer Stromermittlungseinrichtung (7) zugeführt. Die Stromermittlungseinrichtung (7) ermittelt unter Verwertung der Spannung (U) mittels eines Modells (8b) des Messabschnitts (6) eine Temperatur (T) des Messabschnitts (6), unter Verwertung der ermittelten Temperatur (T) einen komplexen Widerstand (Z) des Messabschnitts (6) und unter Verwertung des komplexen Widerstands (Z) des Messabschnitts (6) und der Spannung (U) den Strom (I).

## Beschreibung

Die vorliegende Erfindung geht aus von einem Stromermittlungsverfahren für einen in einer Leitung fließenden Strom,
- wobei eine über einem Messabschnitt der Leitung abfallende Spannung messtechnisch erfasst und einer Stromermittlungseinrichtung zugeführt wird.

Die vorliegende Erfindung geht weiterhin aus von einer Stromermittlungseinrichtung zum Ermitteln eines in einer Leitung fließenden Stromes,
- wobei die Stromermittlungseinrichtung einen Messwert für eine über einem Messabschnitt der Leitung abfallende Spannung entgegennimmt.

Die vorliegende Erfindung geht weiterhin aus von einer Messanordnung für einen in einer Leitung fließenden Strom,
- wobei die Messanordnung eine Spannungsmesseinrichtung aufweist, mittels derer eine über einem Messabschnitt der Leitung abfallende Spannung messtechnisch erfasst wird, und
- wobei die Messanordnung eine derartige Stromermittlungseinrichtung aufweist, der die erfasste Spannung zugeführt wird.

Die vorliegende Erfindung geht weiterhin aus von einem Drehstellungsermittlungsverfahren für eine Drehstellung einer geberlosen Drehstrommaschine, die über Phasenleitungen durch einen Umrichter gespeist wird,
- wobei in den Phasenleitungen fließende Phasenströme ermittelt werden und unter Verwertung der ermittelten Phasenströme die Drehstellung der Drehstrommaschine ermittelt wird.

Die vorliegende Erfindung geht weiterhin aus von einer Drehstellungsermittlungseinrichtung zum Ermitteln einer Drehstellung einer geberlosen Drehstrommaschine, die über Phasenleitungen durch einen Umrichter gespeist wird,
- wobei die Drehstellungsermittlungseinrichtung eine Lageermittlungseinrichtung aufweist, der in den Phasenleitungen fließende Phasenströme zugeführt werden und die unter Verwertung der zugeführten Phasenströme die Drehstellung der Drehstrommaschine ermittelt,
- wobei die Drehstellungsermittlungseinrichtung für jede Phasenleitung eine jeweilige Stromermittlungseinrichtung aufweist,
- wobei die Stromermittlungseinrichtungen so wie obenstehend erläutert ausgebildet sind und
- wobei die Stromermittlungseinrichtungen die von ihnen ermittelten Phasenströme der Lageermittlungseinrichtung zuführen.

Ein Umrichter wird oftmals dazu verwendet, eine Drehstrommaschine zu speisen. Um eine korrekte Speisung der Drehstrommaschine vorzunehmen - insbesondere um die einzelnen Halbleiterschalter des Umrichters richtig zu schalten -, ist es in vielen Fällen erforderlich, die Drehstellung der Drehstrommaschine zu kennen.

Um die Drehstellung der Drehstrommaschine zu kennen, kann die Drehstrommaschine einen Drehgeber aufweisen. In diesem Fall steht die Drehstellung der Drehstrommaschine direkt als Messwert zur Verfügung. In anderen Fällen ist die Drehstrommaschine als geberlose Drehstrommaschine ausgebildet. In diesen Fällen wird die Drehstellung der Drehstrommaschine rechnerisch ermittelt. Als Grundlage für die rechnerische Ermittlung der Drehstellung dienen - ausschließlich oder unter anderem - die in den Phasenleitungen der Drehstrommaschine fließenden Phasenströme. Die Phasenströme müssen daher bei einer geberlosen Drehstrommaschine mit hoher Genauigkeit gemessen oder ermittelt werden.

Im Stand der Technik werden zur genauen Messung bzw. Ermittlung der Phasenströme in der Regel Shunts verwendet. Shunts sind eigenständige Bauelemente mit einem sehr kleinen Widerstand, meist im einstelligen Milliohm-Bereich. Typisch sind Werte von 1 mΩ bis 2 mΩ. Shunts weisen in der Regel einen sehr niedrigen Temperaturkoeffizienten auf, d.h. eine nur sehr geringe Änderung ihres Widerstandswertes in Abhängigkeit von der Temperatur. Shunts bestehen daher in der Regel aus speziellen Metalllegierungen, beispielsweise Konstantan oder Manganin. Aus diesem Grund sind Shunts relativ teuer. Die Shunts werden entweder im Halbleiter-Leistungsmodul des Umrichters oder auf einer Leiterplatte montiert. Die über dem Shunt abfallende Spannung wird erfasst und über den Widerstandswert des Shunts in eine Spannung umgerechnet. Der Widerstandswert des Shunts wird als konstant angenommen. Etwaige Fehler werden hingenommen, da sie aufgrund des sehr niedrigen Temperaturkoeffizienten als hinreichend klein angenommen werden.

Die Aufgabe der vorliegenden Erfindung besteht darin, eine genaue Strommessung auch dann vornehmen zu können, wenn ein Messabschnitt einer Leitung, in welcher der Strom fließt, einen hohen Temperaturkoeffizienten aufweist.

Die Aufgabe wird durch ein Stromermittlungsverfahren mit den Merkmalen des Anspruchs 1 gelöst. Vorteilhafte Ausgestaltungen des Stromermittlungsverfahrens sind Gegenstand der abhängigen Ansprüche 2 bis 4.

Erfindungsgemäß wird ein Stromermittlungsverfahren der eingangs genannten Art dadurch ausgestaltet,
- dass die Stromermittlungseinrichtung unter Verwertung der Spannung mittels eines Modells des Messabschnitts eine Temperatur des Messabschnitts ermittelt, unter Verwertung der ermittelten Temperatur einen komplexen Widerstand des Messabschnitts ermittelt und unter Verwertung des komplexen Widerstands des Messabschnitts und der Spannung den Strom ermittelt.

Unter "Leitung" im Sinne der vorliegenden Erfindung ist eine reine Leitung ohne Schaltelemente oder dergleichen zu verstehen. Insbesondere wird der Widerstand der Leitung nicht über Steuergrößen oder dergleichen aktiv eingestellt. Es ist lediglich der Einfluss der Temperatur auf den Widerstand gegeben, wie er durch den Temperaturkoeffizienten zum Ausdruck gebracht wird. Der Widerstand als solcher ist also ein linearer Widerstand. Die Leitung kann als auf einer Leiterplatte angeordnete Leiterbahn ausgebildet sein.

Geeignete Modelle zur Ermittlung der Temperatur des Messabschnitts und der hierauf aufbauenden Temperatur des komplexen Widerstands des Messabschnitts sind als solche bekannt. Insbesondere sind Modelle bekannt, die in Abhängigkeit vom Strom durch einen Halbleiterschalter, das heißt einem nichtlinearen Widerstand, die Temperatur des Halbleiterschalters ermitteln. Eingangsgrößen des Modells sind eine Anfangstemperatur des Halbleiterschalters und - als Funktion der Zeit - die Verlustleistung oder der Verlustleistung zugrundeliegende Größen. Derartige Modelle können auch vorliegend verwendet werden. Sie können sogar vereinfacht werden, da der Widerstand der Leitung als linearer Widerstand angesetzt werden kann. Dies steht im Gegensatz zu einem Halbleiterschalter, bei welchem der Widerstand als nichtlinearer Widerstand angesetzt werden muss. Es ist somit lediglich erforderlich, einmal die Widerstandskennlinie (d.h. den Widerstand als Funktion der Temperatur) zu erfassen und die Widerstandskennlinie der Stromermittlungseinrichtung vorzugeben. Die Erfassung der Widerstandskennlinie kann über einen Versuchsaufbau erfolgen.

Wie bei bekannten Modellen für nichtlineare Halbleiterschalter ermittelt die Stromermittlungseinrichtung auch im Rahmen des erfindungsgemäßen Stromermittlungsverfahrens vorzugsweise unter Verwertung der Spannung und/oder des Stroms eine in dem Messabschnitt anfallende Verlustleistung und führt anhand der Verlustleistung die Temperatur des Messabschnitts nach.

Es ergibt sich somit der Sachverhalt, dass die Verlustleistung vom Strom, die Temperaturänderung von der Verlustleistung und der Strom wiederum von der Temperatur abhängt. Dennoch ist eine Modellierung problemlos möglich. Denn das Modell wird zeitdiskret gerechnet. Beispielsweise ist es möglich, für jeden Zyklus den im vorherigen Zyklus ermittelten Wert für die Temperatur des Messabschnitts anzusetzen, für diese Temperatur den zugehörigen Strom zu ermitteln und als gültigen Strom zu verwerten und anhand des so ermittelten gültigen Stroms die Verlustleistung und hierauf aufbauend die Änderung der Temperatur zu ermitteln und für den nächsten Zyklus die entsprechend geänderte Temperatur zu verwenden.

Im Rahmen des erfindungsgemäßen Stromermittlungsverfahrens werden die Erfassung der Spannung und die darauf aufbauende Ermittlung der Temperatur des Messabschnitts und des in der Leitung fließenden Stromes zyklisch wiederholt. Die Zykluszeit kann beispielsweise im Bereich weniger Millisekunden liegen.

Zu Beginn des Stromermittlungsverfahrens muss das Modell initialisiert werden. Dies kann insbesondere dadurch erfolgen, dass die Stromermittlungseinrichtung zu Beginn des Stromermittlungsverfahrens eine messtechnisch in der Umgebung des Messabschnitts erfasste anfängliche Temperatur entgegennimmt und die anfängliche Temperatur im Rahmen einer Initialisierung des Modells berücksichtigt.

Die Aufgabe wird weiterhin durch eine Stromermittlungseinrichtung mit den Merkmalen des Anspruchs 5 gelöst. Vorteilhafte Ausgestaltungen der Stromermittlungseinrichtung sind Gegenstand der abhängigen Ansprüche 6 und 7.

Erfindungsgemäß wird eine Stromermittlungseinrichtung der eingangs genannten Art derart ausgestaltet, dass die Stromermittlungseinrichtung derart ausgebildet ist, dass sie unter Verwertung der messtechnisch erfassten Spannung mittels eines Modells des Messabschnitts eine Temperatur des Messabschnitts ermittelt, unter Verwertung der ermittelten Temperatur einen komplexen Widerstand des Messabschnitts ermittelt und unter Verwertung des komplexen Widerstands des Messabschnitts und der Spannung den Strom ermittelt.

Mit dieser Stromermittlungseinrichtung sind die gleichen Vorteile erzielbar wie durch das erfindungsgemäße Stromermittlungsverfahren.

Die vorteilhaften Ausgestaltungen der Stromermittlungseinrichtung korrespondieren mit denen des erfindungsgemäßen Stromermittlungsverfahrens. Auch die hierdurch erzielbaren Vorteile sind dieselben.

Die Aufgabe wird weiterhin durch eine Messanordnung mit den Merkmalen des Anspruchs 8 gelöst. Vorteilhafte Ausgestaltungen der Messanordnung sind Gegenstand der abhängigen Ansprüche 9 bis 11.

Erfindungsgemäß wird eine Messanordnung der eingangs genannten Art dadurch ausgestaltet, dass die Stromermittlungseinrichtung als erfindungsgemäße Stromermittlungseinrichtung ausgebildet ist.

Vorzugsweise ist zumindest der Messabschnitt - gegebenenfalls auch die gesamte Leitung - an einen Wärmepuffer angekoppelt, dessen Wärmekapazität größer als die Wärmekapazität des Messabschnitts ist. Eine gute thermische Ankopplung des Messabschnitts an den Wärmepuffer - so wie obenstehend erläutert - stellt einen deutlichen Vorteil dar. Insbesondere wird dadurch erreicht, dass die Temperatur einer Änderung des Stroms nur mit einer relativ großen Verzögerungszeit folgt. Im Ergebnis kann daher die Stromermittlungseinrichtung mit einer relativ langen Zykluszeit arbeiten und dennoch den Strom mit hoher Genauigkeit ermitteln.

Zur Realisierung des Wärmepuffers und zur Realisierung der thermischen Ankopplung des Messabschnitts an den Wärmepuffer ist es insbesondere möglich, dass der Messabschnitt auf einer Seite einer Leiterplatte angeordnet ist und der Wärmepuffer die Leiterplatte selbst ist oder als auf der anderen Seite der Leiterplatte angeordneter Kühlkörper ausgebildet ist. Beispielsweise kann der Messabschnitt oder die gesamte Leitung gemäß dem DCB (= direct copper bonding) auf der Leiterplatte angeordnet sein.

Durch die erfindungsgemäßen Ausgestaltungen wird unter anderem auch erreicht, dass an das Material der Leitung innerhalb des Messabschnitts keine besonderen Anforderungen gestellt werden müssen. Insbesondere ist es daher möglich, dass die Leitung in Richtung des Stromflusses gesehen vor und hinter dem Messabschnitt aus dem gleichen Material besteht wie der Messabschnitt. Eine Ausgestaltung des Messabschnitts aus einer besonderen Legierung (beispielsweise Konstantan oder Manganin) ist zwar möglich, im Gegensatz zum Stand der Technik aber nicht erforderlich.

Die Aufgabe wird weiterhin durch ein Drehstellungsermittlungsverfahren für eine Drehstellung einer geberlosen Drehstrommaschine mit den Merkmalen des Anspruchs 12 gelöst. Erfindungsgemäß wird ein Drehstellungsermittlungsverfahren der eingangs genannten Art, dadurch ausgestaltet, dass die Phasenströme jeweils gemäß einem erfindungsgemäßen Stromermittlungsverfahren ermittelt werden.

Die Aufgabe wird weiterhin durch eine Drehstellungsermittlungseinrichtung zum Ermitteln einer Drehstellung einer geberlosen Drehstrommaschine mit den Merkmalen des Anspruchs 13 gelöst. Erfindungsgemäß wird eine Drehstellungsermittlungseinrichtung der eingangs genannten Art dadurch ausgestaltet, dass die Stromermittlungseinrichtungen als erfindungsgemäße Stromermittlungseinrichtungen ausgebildet sind.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: eine Messanordnung,
- FIG 2: ein Ablaufdiagramm,
- FIG 3: eine Leiterplatte von der Seite,
- FIG 4: eine weitere Leiterplatte von der Seite,
- FIG 5: eine Leiterplatte von oben und
- FIG 6: einen Umrichter und eine Drehstrommaschine.

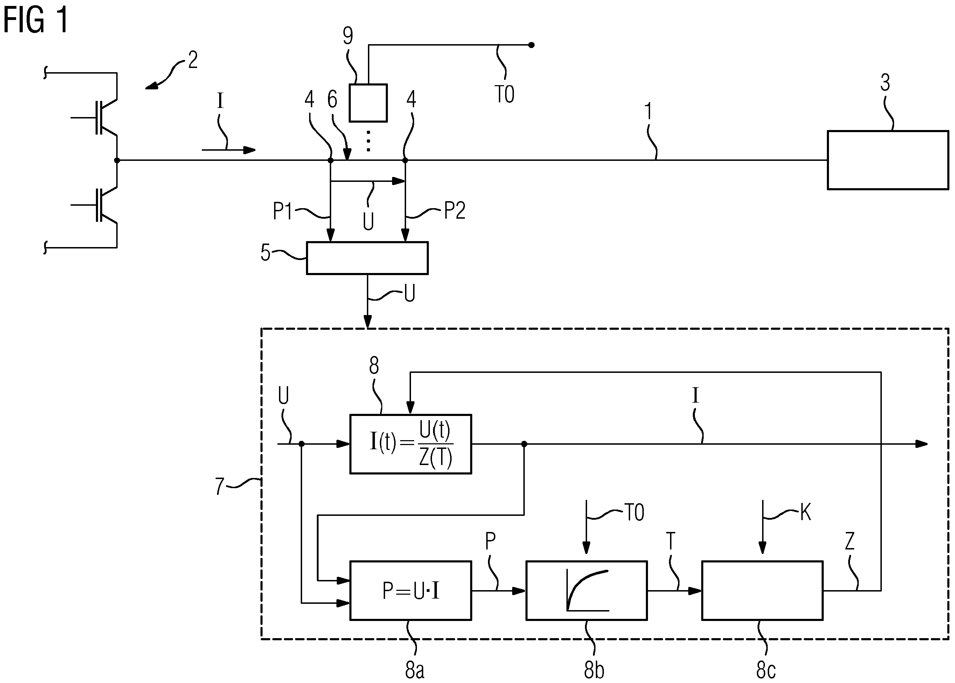

Gemäß FIG 1 fließt in einer Leitung 1 ein Strom I. Der Strom I kann beispielsweise über eine Halbbrücke 2 einer Umrichtereinheit einer Last 3 zugeführt werden. Die Art und Weise der Einspeisung des Stromes I ist zwar üblich, im Rahmen der Messanordnung als solche aber von untergeordneter Bedeutung. Auch die Art der Last 3 ist im Rahmen der Messanordnung als solche von untergeordneter Bedeutung.

An zwei Stellen der Leitung 1 befinden sich Abgriffe 4, an denen das jeweilige Potenzial P1, P2 abgegriffen und einer Spannungsmesseinrichtung 5 zugeführt wird. Die Spannungsmesseinrichtung 5 ermittelt die Differenz der Potenziale P1, P2 und damit die Spannung U, die zwischen den beiden Abgriffen 4 abfällt. Der Abschnitt 6 der Leitung 1, der sich zwischen den beiden Abgriffen 4 befindet, stellt somit einen Messabschnitt 6 dar. Die Spannungsmesseinrichtung 5 erfasst somit messtechnisch die über dem Messabschnitt 6 abfallende Spannung U. die Abgriffe 4 können mit der Spannungsmesseinrichtung 5 beispielsweise über Bonddrähte verbunden sein.

Der Widerstandswert der Leitung 1 zwischen den beiden Abgriffen 4 liegt meist im Bereich weniger mΩ. Selbst bei einem hohen Strom I von 100 A und mehr liegt die Differenz der Potenziale P1, P2 und damit die Spannung U in der Regel unter 1 V, maximal geringfügig darüber.

Die Spannungsmesseinrichtung 5 führt die Spannung U (genauer: den entsprechenden Messwert) einer Stromermittlungseinrichtung 7 zu. Die Stromermittlungseinrichtung 7 ist ebenfalls Bestandteil der Messanordnung. Die Stromermittlungseinrichtung 7 dient der Ermittlung des Stromes I, der in der Leitung 1 fließt.

Die Stromermittlungseinrichtung 7 nimmt die Spannung U (genauer: den entsprechenden Messwert) entgegen. Die Stromermittlungseinrichtung 7 weist einen Stromermittlungsblock 8 auf. In dem Stromermittlungsblock 8 ermittelt die Stromermittlungseinrichtung 7 anhand der Spannung U in Verbindung mit einem komplexen Widerstand Z des Messabschnitts 6 den Strom I.

Die Stromermittlungseinrichtung 7 weist weiterhin einen Leistungsermittlungsblock 8a auf. In dem Leistungsermittlungsblock 8a ermittelt die Stromermittlungseinrichtung 7 eine in dem Messabschnitt 6 anfallende Verlustleistung P. Die Stromermittlungseinrichtung 7 kann zur Ermittlung der Verlustleistung P entsprechend der Darstellung in FIG 1 beispielsweise das Produkt der erfassten Spannung U und des ermittelten Stromes I bilden. In diesem Fall sind die Spannung U und der Strom I die Eingangsgrößen des Leistungsermittlungsblocks 8a. Alternativ ist es möglich, das Quadrat der erfassten Spannung U durch den ohmschen Widerstand des Messabschnitts 6 zu dividieren oder das Quadrat des ermittelten Stromes I mit dem ohmschen Widerstand des Messabschnitts 6 zu multiplizieren. In diesen beiden Fällen sind die Spannung U oder der Strom I und der ohmsche Widerstand des Messabschnitts 6 die Eingangsgrößen des Leistungsermittlungsblocks 8a. Der ohmsche Widerstand des Messabschnitts 6 kann ohne weiteres aus dem komplexen Widerstand Z des Messabschnitts 6 ermittelt werden.

Die Stromermittlungseinrichtung 7 weist weiterhin ein Modell 8b des Messabschnitts 6 auf. Das Modell 8b kann alternativ in Software oder in Hardware implementiert sein. Es modelliert das Temperaturverhalten des Messabschnitts 6. Dem Modell 8b wird die Verlustleistung P zugeführt. Mittels des Modells 8b führt die Stromermittlungseinrichtung 7 eine Temperatur T des Messabschnitts 6 nach. Eingangsgröße des Modells 8b ist also die Verlustleistung P, Ausgangsgröße die Temperatur T.

Die Stromermittlungseinrichtung 7 weist weiterhin einen Widerstandsermittlungsblock 8c auf. Dem Widerstandsermittlungsblock 8c wird die Temperatur T zugeführt. In dem Widerstandsermittlungsblock 8c ermittelt die Stromermittlungseinrichtung 7 unter Verwertung der Temperatur T den komplexen Widerstand Z des Messabschnitts 6. Die Stromermittlungseinrichtung 7 verwertet neben der Temperatur T lediglich noch eine Kennlinie K des Messabschnitts 6. Die Kennlinie K kann vorab ermittelt werden und im Rahmen der Inbetriebnahme der Stromermittlungseinrichtung 7 der Stromermittlungseinrichtung 7 vorgegeben werden.

An variablen gemessenen Größen benötigt die Stromermittlungseinrichtung 7 somit lediglich die Spannung U. Alle anderen Größen ermittelt die Stromermittlungseinrichtung 7 intern.

Zur korrekten Ermittlung der Temperatur T mittels des Modells 8b ist es erforderlich, das Modell 8b korrekt zu initialisieren. Zu diesem Zweck wird zu Beginn des Stromermittlungsverfahrens - also bei einer Inbetriebnahme nach einer längeren Pause - mittels eines Temperatursensors 9 messtechnisch eine anfängliche Temperatur TO erfasst, die in der Umgebung des Messabschnitts 6 vorliegt. Die Stromermittlungseinrichtung 7 nimmt die anfängliche Temperatur TO (genauer: den entsprechenden Messwert) entgegen und berücksichtigt die anfängliche Temperatur TO im Rahmen einer Initialisierung des Modells 8b. Insbesondere kann angenommen werden, dass auch der Messabschnitt 6 anfänglich diese Temperatur TO aufweist.

Die obenstehend erläuterte Betriebsweise der Stromermittlungseinrichtung 7 stellt einen laufenden Betrieb dar. Die Stromermittlungseinrichtung 7 nimmt also immer wieder einen jeweils aktuellen Wert der Spannung U entgegen, ermittelt hierauf basierend den jeweiligen Strom I, führt die Temperatur T nach und ermittelt den jeweiligen komplexen Widerstand Z des Messabschnitts 6.

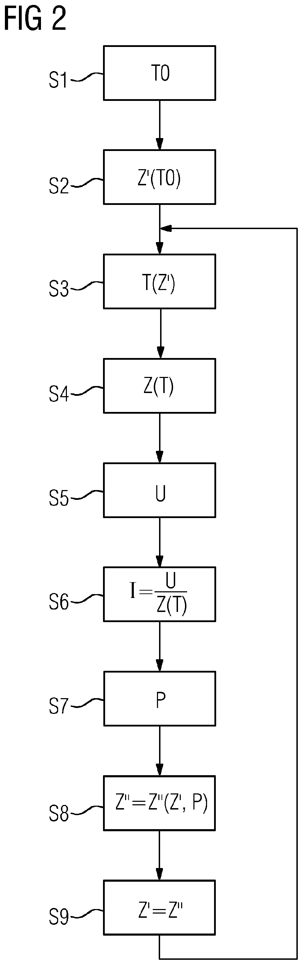

Die beschriebene Vorgehensweise, gemäß welcher der Strom (unter anderem) vom komplexen Widerstand Z des Messabschnitts 6 abhängt und der komplexe Widerstand Z (über den ohmschen Widerstand) in die Ermittlung der Verlustleistung P und damit wieder in die Ermittlung der Temperatur T eingeht, wobei die Temperatur wiederum den komplexen Widerstand Z beeinflusst, stellt nur scheinbar einen Zirkelschluss dar. Denn in der Praxis erfolgt die Ermittlung des Stromes I im Gegentakt zum Nachführen der Temperatur T. Für die Ermittlung des Stromes I wird also für die Temperatur T der zuletzt ermittelte Wert herangezogen und erst nach der Ermittlung des Stromes I wird die Temperatur T mit diesem ermittelten Wert für den Strom I nachgeführt. Dies wird nachfolgend in Verbindung mit FIG 2 erläutert.

Gemäß FIG 2 nimmt die Stromermittlungseinrichtung 7 in einem Schritt S1 die anfängliche Temperatur TO entgegen. In einem Schritt S2 initialisiert die Stromermittlungseinrichtung 7 das Modell 8b mit der anfänglichen Temperatur TO. Insbesondere definiert sie einen relevanten Zustand Z' für den Messabschnitt 6. Der Zustand Z' beschreibt den aktuellen thermischen Zustand des Messabschnitts 6.

In einem Schritt S3 ermittelt die Stromermittlungseinrichtung 7 anhand des Zustands Z' die Temperatur T des Messabschnitts 6. In einem Schritt S4 ermittelt die Stromermittlungseinrichtung 7 anhand der Temperatur T - also derjenigen Temperatur wie sie durch den momentanen Zustand Z' des Modells 8b definiert ist - den komplexen Widerstand Z des Messabschnitts 6. In einem Schritt S5 nimmt die Stromermittlungseinrichtung 7 die Spannung U entgegen. In einem Schritt S6 ermittelt die Stromermittlungseinrichtung 7 den Strom I und gibt den entsprechenden ermittelten Wert aus. In die Ermittlung des Stromes I gehen die erfasste Spannung U und der im Schritt S4 ermittelte komplexe Widerstand Z des Messabschnitts 6 ein. In einem Schritt S7 ermittelt die Stromermittlungseinrichtung 7 die Verlustleistung P.

In einem Schritt S8 ermittelt die Stromermittlungseinrichtung 7 einen neuen Zustand Z" des Messabschnitts 6. Der im Schritt S8 ermittelte neue Zustand Z" ist zum einen vom bisherigen Zustand Z' des Messabschnitts 6 und zum anderen von der Verlustleistung P abhängig. In einem Schritt S9 übernimmt die Stromermittlungseinrichtung 7 sodann den im Schritt S8 ermittelten Zustand Z" als neuen Zustand Z' für den Messabschnitt 6. Sodann geht die Stromermittlungseinrichtung 7 zum Schritt S3 zurück.

Aus diesen Ausführungen ist insbesondere ersichtlich, dass die Erfassung der Spannung U und die darauf aufbauende Ermittlung des in der Leitung 1 fließenden Stromes I und der Temperatur T des Messabschnitts 6 wiederholt werden. Weiterhin ist aus diesen Ausführungen ersichtlich, dass das Ermitteln des Stromes I und der Verlustleistung P (Schritte S6 und S7) auf der einen Seite und das Nachführen des Zustands Z' und damit der Temperatur T des Messabschnitts 6 (Schritte S9 und S3) im Gegentakt ausgeführt werden.

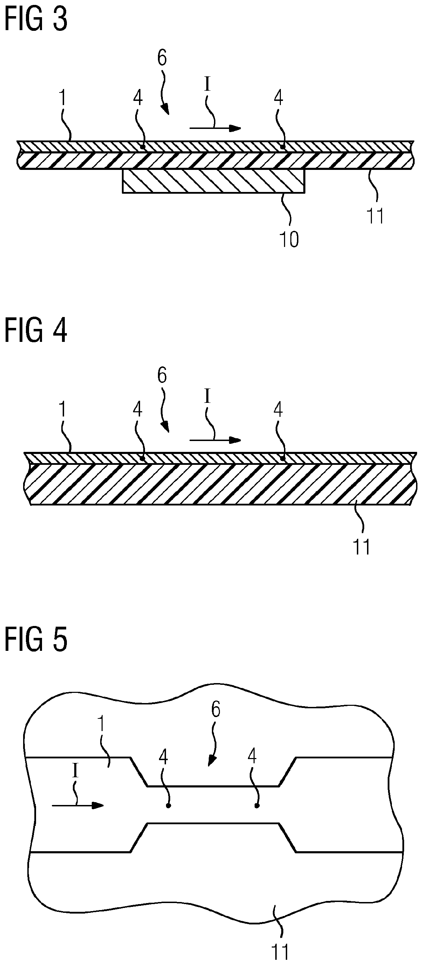

Nachfolgend werden in Verbindung mit den FIG 3 bis 5 mögliche und vorteilhafte konstruktive Ausgestaltungen der Messanordnung erläutert.

Gemäß den FIG 3 und 4 ist der Messabschnitt 6 an einen Wärmepuffer angekoppelt. Die Wärmekapazität des Wärmepuffers ist größer - in der Regel erheblich größer - als die Wärmekapazität des Messabschnitts 6. Insbesondere kann der Messabschnitt 6 entsprechend der Darstellung in den FIG 3 und 4 auf einer Seite einer Leiterplatte 11 angeordnet sein, beispielsweise mittels DCB. Der Wärmepuffer kann - so wie der Wärmepuffer von FIG 3 - als Kühlkörper 10 ausgebildet sein, der auf der anderen Seite der Leiterplatte 11 angeordnet ist. Alternativ kann der Wärmepuffer - so wie der Wärmepuffer von FIG 4 - die Leiterplatte 11 selbst sein. Unabhängig davon, ob die eine oder die andere Ausgestaltungen realisiert wird, wird durch den Wärmepuffer erreicht, dass die Temperatur T des Messabschnitts 6 dem Strom I nur träge folgt. Trotz schneller Schwankungen des Stromes I ist es daher möglich, die Vorgehensweise der FIG 1 und 2 mit einer relativ großen Zykluszeit auszuführen, beispielsweise mit einer Zykluszeit im Millisekundenbereich.

An den Messabschnitt 6 sind keine besonderen Anforderungen zu stellen. Insbesondere ist es möglich, dass entsprechend der Darstellung in FIG 5 die Leitung 1 in Richtung des Stromflusses gesehen vor und hinter dem Messabschnitt 6 aus dem gleichen Material besteht wie der Messabschnitt 6. Beispielsweise kann die Leitung einschließlich des Messabschnitts 6 aus Kupfer bestehen. Es ist jedoch möglich, dass der Messabschnitt 6 gegenüber der Leitung vor und hinter dem Messabschnitt 6 verjüngt ist, also einen geringeren Querschnitt für den zu führenden Strom I aufweist.

Die Ausgestaltung von FIG 5 kann unabhängig von den Ausgestaltungen der FIG 3 und 4 realisiert sein. Sie kann nach Bedarf aber auch mit einer der Ausgestaltungen von FIG 3 und 4 kombiniert werden.

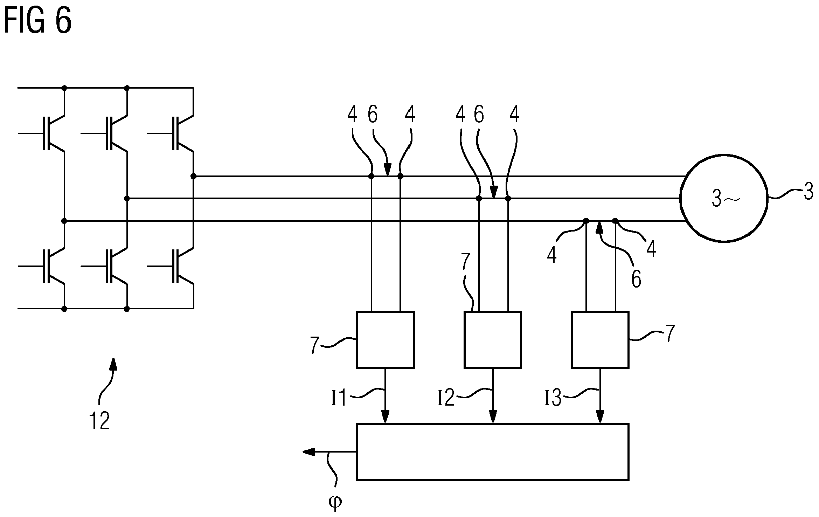

Die erfindungsgemäße Art und Weise der Ermittlung des Stromes I kann entsprechend der Darstellung in FIG 6 genutzt werden.

Gemäß FIG 6 ist die Last 3 als geberlose Drehstrommaschine ausgebildet, die durch einen Umrichter 12 gespeist wird. Es handelt sich also um eine rotatorische Drehstrommaschine, bei welcher die Drehstellung ϕ des Rotors der Drehstrommaschine zwar bekannt sein muss, aber nicht mittels eines entsprechenden Drehstellungsgebers direkt erfasst wird. Das Speisen der Drehstrommaschine erfolgt über Phasenleitungen 13.

Für derartige Drehstrommaschinen ist bekannt, die Drehstellung ϕ unter Verwertung von Phasenströmen I1, I2, I3 zu ermitteln. Gemäß der Darstellung in FIG 6 weist eine zugehörige Drehstellungsermittlungseinrichtung eine Lageermittlungseinrichtung 14 auf. Die Phasenströme I1, I2, I3 werden der Lageermittlungseinrichtung 14 zugeführt, welche unter Verwertung der Phasenströme I1, I2, I3 die Drehstellung ϕ der Drehstrommaschine 3 ermittelt. Diese Vorgehensweise ist Fachleuten allgemein bekannt und muss daher nicht detailliert erläutert werden.

Entscheidend kommt es im Rahmen der vorliegenden Erfindung auf die Art und Weise an, auf welche die Phasenströme I1, I2, I3 bereitgestellt werden. Denn gemäß FIG 6 weisen die Phasenleitungen 13 jeweils einen eigenen Messabschnitt 6 auf, denen jeweils eine eigene Stromermittlungseinrichtung 7 zugeordnet ist. Die Stromermittlungseinrichtungen 7 sind so ausgebildet, wie dies obenstehend in Verbindung mit den FIG 1-5 erläutert wurde. Mittels der Stromermittlungseinrichtungen 7 können daher - so wie obenstehend erläutert - die Phasenströme I1, I2, I3 ermittelt werden.

Zusammengefasst betrifft die vorliegende Erfindung somit folgenden Sachverhalt:
In einer Leitung 1 fließt ein Strom I. Eine über einem Messabschnitt 6 der Leitung 1 abfallende Spannung U wird messtechnisch erfasst und einer Stromermittlungseinrichtung 7 zugeführt. Die Stromermittlungseinrichtung 7 ermittelt unter Verwertung der Spannung U mittels eines Modells 8b des Messabschnitts 6 eine Temperatur T des Messabschnitts 6, unter Verwertung der ermittelten Temperatur T einen komplexen Widerstand Z des Messabschnitts 6 und unter Verwertung des komplexen Widerstands Z des Messabschnitts 6 und der Spannung U den Strom I.

Die vorliegende Erfindung weist viele Vorteile auf. Insbesondere ist eine Verwendung von teuren Materialien für den Messabschnitt 6 nicht erforderlich. Auch ist es möglich, als Messabschnitt 6 unmittelbar einen Teil der Leitung 1 zu verwenden. Ein diskretes Bauelement (Shunt) ist nicht erforderlich. Das Einsparungspotenzial liegt bei mehreren Euro. Auch ist der Aufbau robust und zuverlässig. Die Aufbauverbindungstechnik vereinfacht sich erheblich. Der Messabschnitt 6 kann integraler Bestandteil einer den Umrichter 12 umfassenden Baueinheit sein. Auch ergeben sich größere Freiheiten beim Design. Die erforderliche Software zum Modellieren des Temperaturverhaltens des Messabschnitts 6 und der daraus resultierenden Änderung des komplexen Widerstands Z des Messabschnitts 6 kann von Vorgehensweisen für Halbleiterschalter übernommen werden. Zur Implementierung der Stromermittlung können Sigma-Delta-Wandler verwendet werden, die üblicherweise einen leistungsfähigen Prozessor zur Berechnung einer entsprechenden Filterfunktion aufweisen. Der Prozessor kann ohne weiteres derart modifiziert werden, dass er die stromabhängige Änderung des komplexen Widerstands Z des Messabschnitts 6 mit berechnet.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Stromermittlungsverfahren für einen in einer Leitung (1) fließenden Strom (I),
- wobei eine über einem Messabschnitt (6) der Leitung (1) abfallende Spannung (U) messtechnisch erfasst und einer Stromermittlungseinrichtung (7) zugeführt wird,
- wobei die Stromermittlungseinrichtung (7) unter Verwertung der Spannung (U) mittels eines Modells (8b) des Messabschnitts (6) eine Temperatur (T) des Messabschnitts (6) ermittelt, unter Verwertung der ermittelten Temperatur (T) einen komplexen Widerstand (Z) des Messabschnitts (6) ermittelt und unter Verwertung des komplexen Widerstands (Z) des Messabschnitts (6) und der Spannung (U) den Strom (I) ermittelt.

2. Stromermittlungsverfahren nach Anspruch 1,
**dadurch gekennzeichnet,**
**dass** die Stromermittlungseinrichtung (7) unter Verwertung der Spannung (U) und/oder des Stroms (I) eine in dem Messabschnitt (6) anfallende Verlustleistung (P) ermittelt und anhand der Verlustleistung (P) die Temperatur (T) des Messabschnitts (6) nachführt.

3. Stromermittlungsverfahren nach Anspruch 1 oder 2,
**dadurch gekennzeichnet,**
**dass** die Erfassung der Spannung (U) und die darauf aufbauende Ermittlung der Temperatur (T) des Messabschnitts (6) und des in der Leitung fließenden Stromes (I) zyklisch wiederholt werden.

4. Stromermittlungsverfahren nach Anspruch 3,
**dadurch gekennzeichnet,**
**dass** die Stromermittlungseinrichtung (7) zu Beginn des Stromermittlungsverfahrens eine messtechnisch in der Umgebung des Messabschnitts (6) erfasste anfängliche Temperatur (TO) entgegennimmt und die anfängliche Temperatur (TO) im Rahmen einer Initialisierung des Modells (8b) berücksichtigt.

5. Stromermittlungseinrichtung zum Ermitteln eines in einer Leitung (1) fließenden Stromes (I),
- wobei die Stromermittlungseinrichtung einen Messwert für eine über einem Messabschnitt (6) der Leitung (1) abfallende Spannung (U) entgegennimmt,
- wobei die Stromermittlungseinrichtung derart ausgebildet ist, dass sie unter Verwertung der messtechnisch erfassten Spannung (U) mittels eines Modells (8b) des Messabschnitts (6) eine Temperatur (T) des Messabschnitts (6) ermittelt, unter Verwertung der ermittelten Temperatur (T) einen komplexen Widerstand (Z) des Messabschnitts (6) ermittelt und unter Verwertung des komplexen Widerstands (Z) des Messabschnitts (6) und der Spannung (U) den Strom (I) ermittelt.

6. Stromermittlungseinrichtung nach Anspruch 5,
**dadurch gekennzeichnet,**
**dass** die Stromermittlungseinrichtung derart ausgebildet ist, dass sie unter Verwertung der Spannung (U) und/oder des Stroms (I) eine in dem Messabschnitt (6) anfallende Verlustleistung (P) ermittelt und anhand der Verlustleistung (P) die Temperatur (T) des Messabschnitts (6) nachführt.

7. Stromermittlungseinrichtung nach Anspruch 5 oder 6,
**dadurch gekennzeichnet,**
**dass** die Stromermittlungseinrichtung derart ausgebildet ist, dass sie zu Beginn des Stromermittlungsverfahrens das Modell (8b) mit einer messtechnisch in der Umgebung des Messabschnitts (6) erfassten anfänglichen Temperatur (TO) initialisiert.

8. Messanordnung für einen in einer Leitung (1) fließenden Strom (I),
- wobei die Messanordnung eine Spannungsmesseinrichtung (5) aufweist, mittels derer eine über einem Messabschnitt (6) der Leitung (1) abfallende Spannung (U) messtechnisch erfasst wird, und
- wobei die Messanordnung eine Stromermittlungseinrichtung (7) nach Anspruch 5, 6 oder 7 aufweist, der die erfasste Spannung (U) zugeführt wird.

9. Messanordnung nach Anspruch 8,
**dadurch gekennzeichnet,**
**dass** zumindest der Messabschnitt (6) an einen Wärmepuffer angekoppelt ist, dessen Wärmekapazität größer als die Wärmekapazität des Messabschnitts (6) ist.

10. Messanordnung nach Anspruch 9,
**dadurch gekennzeichnet,**
**dass** der Messabschnitt (6) auf einer Seite einer Leiterplatte (11) angeordnet ist und dass der Wärmepuffer die Leiterplatte (11) selbst ist oder als auf der anderen Seite der Leiterplatte (11) angeordneter Kühlkörper (10) ausgebildet ist.

11. Messanordnung nach Anspruch 8, 9 oder 10,
**dadurch gekennzeichnet,**
**dass** die Leitung (1) in Richtung des Stromflusses gesehen vor und hinter dem Messabschnitt (6) aus dem gleichen Material besteht wie der Messabschnitt (6).

12. Drehstellungsermittlungsverfahren für eine Drehstellung (ϕ) einer geberlosen Drehstrommaschine, die über Phasenleitungen (13) durch einen Umrichter (12) gespeist wird,
- wobei in den Phasenleitungen (13) fließende Phasenströme (I1, I2, I3) ermittelt werden und unter Verwertung der ermittelten Phasenströme (I1, I2, I3) die Drehstellung (ϕ) der Drehstrommaschine ermittelt wird,
- wobei die Phasenströme (I1, I2, I3) jeweils gemäß einem Stromermittlungsverfahren nach einem der Ansprüche 1 bis 4 ermittelt werden.

13. Drehstellungsermittlungseinrichtung zum Ermitteln einer Drehstellung (ϕ) einer geberlosen Drehstrommaschine, die über Phasenleitungen (13) durch einen Umrichter (12) gespeist wird,
- wobei die Drehstellungsermittlungseinrichtung eine Lageermittlungseinrichtung (14) aufweist, der in den Phasenleitungen (13) fließende Phasenströme (I1, I2, I3) zugeführt werden und die unter Verwertung der zugeführten Phasenströme (I1, I2, I3) die Drehstellung (ϕ) der Drehstrommaschine ermittelt,
- wobei die Drehstellungsermittlungseinrichtung für jede Phasenleitung (13) eine jeweilige Stromermittlungseinrichtung (7) aufweist,
- wobei die Stromermittlungseinrichtungen (7) jeweils nach Anspruch 5, 6 oder 7 ausgebildet sind und
- wobei die Stromermittlungseinrichtungen (7) die von ihnen ermittelten Phasenströme (I1, I2, I3) der Lageermittlungseinrichtung (14) zuführen.
